# DEMANDE DE BREVET EUROPEEN

(11) **EP 4 790 528 A1**
(43) Date de publication de la demande: **12.08.2026**
(21) Numéro de dépôt: 26155920.7
(22) Date de dépôt: 03.02.2026
(51) Int. Cl.: G06F 3/041, G06F 3/042, H10K 59/40, G02F 1/1333, G02F 1/1335, G02F 1/13357

(54) **DISPOSITIF DE RÉTROÉCLAIRAGE ET DE DÉTECTION DE GESTES**

(30) Priorité: 07.02.2025 FR 2501292
(71) Demandeur: Commissariat à l'Energie Atomique et aux Energies Alternatives, 75015 Paris (FR)
(72) Inventeur: TEMPLIER, François, 38054 GRENOBLE CEDEX 09 (FR); MAITREJEAN, Sylvain, 38054 GRENOBLE CEDEX 09 (FR)
(74) Mandataire: Cabinet Beaumont

(57) **Abrégé**

La présente description concerne un dispositif de rétroéclairage et de détection de gestes comprenant :
- des premiers éléments (145a) d'émission de lumière blanche ;
- des deuxièmes éléments (145b) d'émission de rayonnements infrarouge ou de lumière visible ; et
- des troisièmes éléments (145c) de détection des rayonnements infrarouge ou de la lumière visible émis(e) par les deuxièmes éléments (145b),
dans lequel les premiers (145a), deuxièmes (145b) et troisièmes (145c) éléments sont connectés électriquement à un même substrat (121).

## Description

### Domaine technique

La présente description concerne de façon générale les dispositifs électroniques, et plus particulièrement les dispositifs d'affichage intégrant une fonction de détection de gestes.

### Technique antérieure

Des dispositifs d'affichage intégrant une fonction de détection de gestes, tels que l'écran à cristaux liquides (« Liquid Crystal Display » - LCD, en anglais) multifonction connu sous la dénomination commerciale « IRIS » de la société Embodme et décrit dans l'article de E. Hemery et E. Santoul intitulé « IRIS: Integrating 3D Sensing with LCD Screens for Enhanced Touch Interaction », ont été proposés. Cet écran comporte une matrice de cristaux liquides rétroéclairée par des diodes électroluminescentes (LED) situées soit sur le pourtour (technologie dite « edge lit », en anglais), soit à l'aplomb (technologie dite « back lit », en anglais) de la matrice de cristaux liquides. L'écran intègre en outre un dispositif de détection de gestes comprenant une matrice de photoémetteurs et de photodétecteurs infrarouge. Dans cet écran, les LED de rétroéclairage et la matrice de photoémetteurs et photodétecteurs infrarouge sont formées sur des substrats distincts.

Les dispositifs d'affichage existants intégrant une fonction de détection de gestes et les procédés de fabrication de tels dispositifs présentent divers inconvénients.

### Résumé de l'invention

Il existe un besoin de pallier tout ou partie des inconvénients des dispositifs d'affichage existants intégrant une fonction de détection de gestes et des procédés de fabrication de tels dispositifs.

Pour cela, un mode de réalisation prévoit un dispositif de rétroéclairage et de détection de gestes comprenant :
- des premiers éléments d'émission de lumière blanche ;
- des deuxièmes éléments d'émission de rayonnements infrarouge ou de lumière visible ; et
- des troisièmes éléments de détection des rayonnements infrarouge ou de la lumière visible émis(e) par les deuxièmes éléments,

dans lequel les premiers, deuxièmes et troisièmes éléments sont connectés électriquement à un même substrat,
le dispositif comprenant une pluralité de puces élémentaires comportant chacune un ou plusieurs éléments parmi l'un des premiers éléments, l'un des deuxièmes éléments et l'un des troisièmes éléments.

Selon un mode de réalisation, le dispositif comprend une pluralité de puces élémentaires comportant chacune l'un des premiers éléments, l'un des deuxièmes éléments et l'un des troisièmes éléments.

Selon un mode de réalisation, chaque puce élémentaire comporte en outre un circuit élémentaire de contrôle des premier, deuxième et troisième éléments.

Selon un mode de réalisation, le dispositif comprend :
- une pluralité de premières puces élémentaires comportant chacune l'un des premiers éléments et l'un des deuxièmes éléments ; et
- une pluralité de deuxièmes puces élémentaires comportant chacune l'un des troisièmes éléments.

Selon un mode de réalisation, chaque première puce élémentaire comporte en outre un circuit élémentaire de contrôle des premier, deuxième et troisième éléments.

Selon un mode de réalisation, chaque troisième élément est un photodétecteur infrarouge à base d'arséniure d'indium-gallium.

Selon un mode de réalisation, le dispositif comprend :
- une pluralité de premières puces élémentaires comportant chacune l'un des premiers éléments ; et
- une pluralité de deuxièmes puces élémentaires comportant chacune l'un des deuxièmes éléments et l'un des troisièmes éléments.

Selon un mode de réalisation, chaque première puce élémentaire comporte en outre un circuit élémentaire de contrôle des premier, deuxième et troisième éléments.

Selon un mode de réalisation, chaque premier élément comprend une première diode électroluminescente surmontée d'un premier convertisseur de couleur.

Selon un mode de réalisation, chaque deuxième élément comprend une deuxième diode électroluminescente surmontée d'un deuxième convertisseur visible vers infrarouge.

Selon un mode de réalisation, les première et deuxième diodes électroluminescentes sont destinées à émettre de la lumière visible dans une même plage de longueurs d'onde, de préférence de la lumière bleue.

Un mode de réalisation prévoit un dispositif d'affichage à cristaux liquides comportant :
- un dispositif de rétroéclairage et de détection de gestes tel que décrit ; et
- à l'aplomb du dispositif de rétroéclairage et de détection de gestes, une matrice de cristaux liquides de part et d'autre de laquelle sont situés des polariseurs.

Un mode de réalisation prévoit un procédé de fabrication d'un dispositif de rétroéclairage et de détection de gestes comportant une étape de formation, sur un même substrat :
- de premiers éléments d'émission de lumière blanche ;
- de deuxièmes éléments d'émission de rayonnements infrarouge ou de lumière visible ; et
- de troisièmes éléments de détection des rayonnements infrarouge ou de la lumière visible émis(e) par les deuxièmes éléments.

Selon un mode de réalisation, le procédé comprend en outre une étape de formation de premières et deuxièmes diodes électroluminescentes des premiers et deuxièmes éléments à partir d'un même empilement actif de diode électroluminescente.

Selon un mode de réalisation, le procédé comprend en outre une étape de formation de premiers convertisseurs de couleur, à l'aplomb des premières diodes électroluminescentes, et de deuxièmes convertisseurs visible vers infrarouge, à l'aplomb des deuxièmes diodes électroluminescentes.

Selon un mode de réalisation, le procédé comprend en outre une étape de report, sur les premières et deuxièmes diodes électroluminescentes, d'un film comprenant :
- des premiers convertisseurs de couleur, destinés à être placés à l'aplomb des premières diodes électroluminescentes ;
- des deuxièmes convertisseurs visible vers infrarouge, destinés à être placés à l'aplomb des deuxièmes diodes électroluminescentes ; et
- des empilements actifs de photodétecteur infrarouge des troisièmes éléments, destinés à être placés à l'aplomb de plots de connexion des troisièmes éléments.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1A, la figure 1B, la figure 1C, la figure 1D, la figure 1E, la figure 1F, la figure 1G, la figure 1H et la figure 1I représentent, par des vues de côté et en coupe, schématiques et partielles, des étapes successives d'un procédé de fabrication d'un dispositif de rétroéclairage et de détection de gestes selon un mode de réalisation ;
la figure 2A et la figure 2B représentent, par des vues de côté et en coupe, schématiques et partielles, des étapes successives d'une variante du procédé de fabrication du dispositif de rétroéclairage et de détection de gestes des figures 1A à 1I ; et
la figure 3 illustre, de façon schématique et partielle, un exemple d'intégration du dispositif de rétroéclairage et de détection de gestes des figures 1A à 1I dans un dispositif d'affichage à cristaux liquides.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les différentes applications des dispositifs de rétroéclairage et de détection de gestes de la présente description, notamment les divers appareils électroniques susceptibles d'intégrer de tels dispositifs, n'ont pas été détaillées, les modes de réalisation décrits étant compatibles avec toutes ou la plupart des applications usuelles et avec tous ou la plupart des appareils électroniques usuels mettant en œuvre un dispositif de rétroéclairage du type de ceux décrits, par exemple des écrans d'affichage à cristaux liquides, moyennant éventuellement des adaptations à la portée de la personne du métier à la lecture de la présente description.

Par ailleurs, la réalisation des circuits de contrôle des dispositifs de rétroéclairage et de détection de gestes n'a pas été détaillée, les modes de réalisation décrits étant compatibles avec les structures et procédés de fabrication usuels de tels circuits intégrés de contrôle.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais « coupled ») entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes « avant », « arrière », « haut », « bas », « gauche », « droite », etc., ou relative, tels que les termes « dessus », « dessous », « supérieur », « inférieur », etc., ou à des qualificatifs d'orientation, tels que les termes « horizontal », « vertical », etc., il est fait référence, sauf précision contraire, à l'orientation des figures.

Sauf précision contraire, les expressions « environ », « approximativement », « sensiblement », et « de l'ordre de » signifient à 10 % ou à 10° près, de préférence à 5 % ou à 5° près.

Sauf précision contraire, les termes « isolant » et « conducteur » signifient respectivement électriquement isolant et électriquement conducteur.

Sauf précision contraire, l'expression « en contact avec » signifie « en contact mécanique avec ».

L'expression « lumière visible » désigne un rayonnement électromagnétique dont la longueur d'onde est comprise entre 400 nm et 700 nm.

L'expression « rayonnement infrarouge » désigne un rayonnement électromagnétique dont la longueur d'onde est comprise entre 700 nm et 1 mm. Dans le domaine infrarouge, le rayonnement infrarouge proche présente une longueur d'onde comprise entre 700 nm et 1,7 µm.

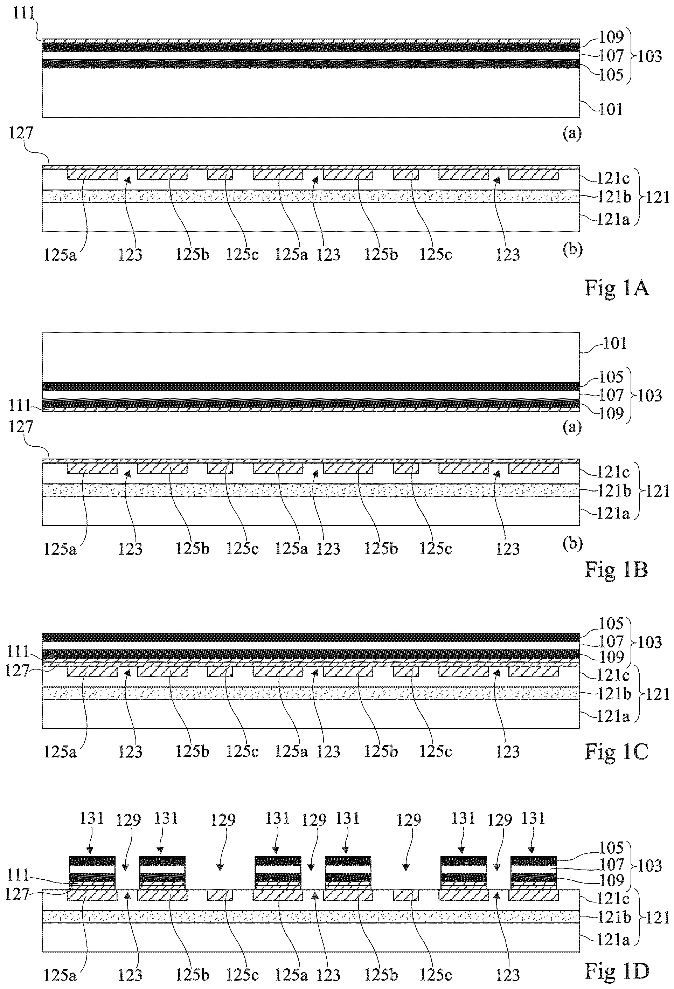

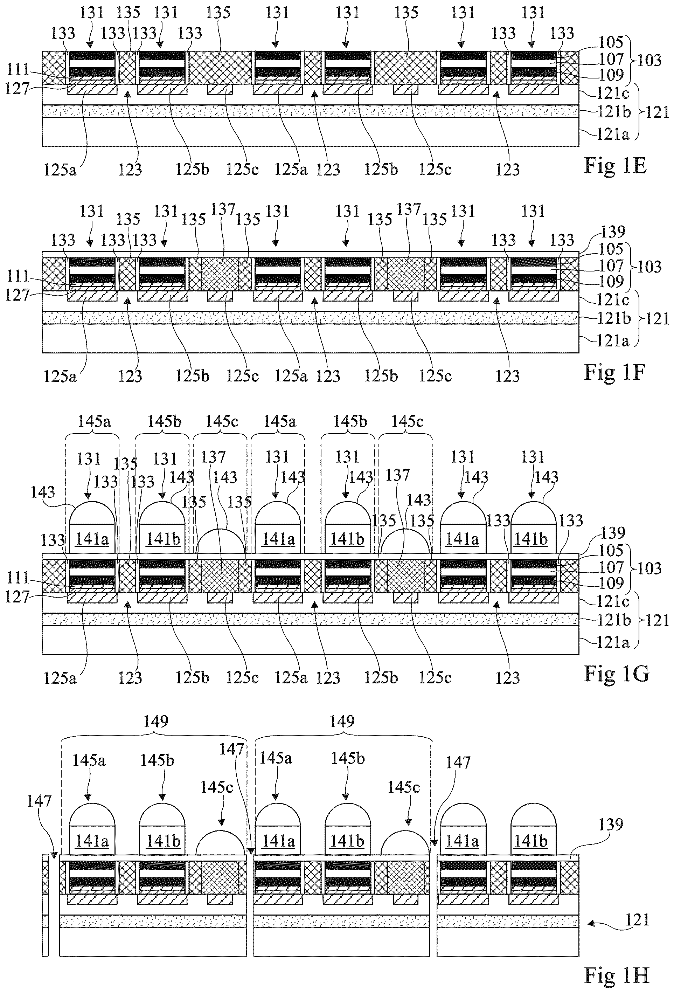

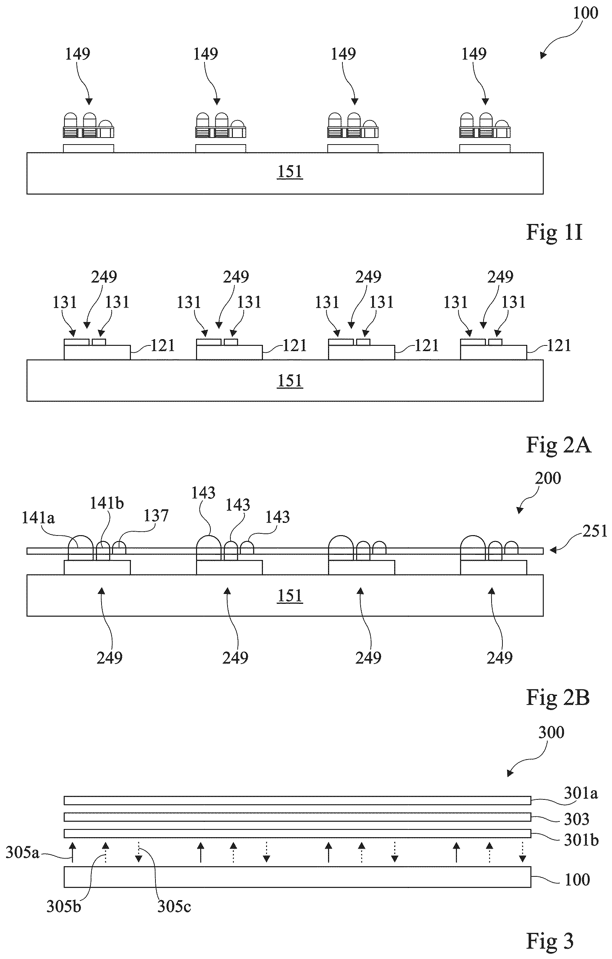

La figure 1A, la figure 1B, la figure 1C, la figure 1D, la figure 1E, la figure 1F, la figure 1G, la figure 1H et la figure 1I représentent, par des vues de côté et en coupe, schématiques et partielles, des étapes successives d'un procédé de fabrication d'un dispositif 100 de rétroéclairage et de détection de gestes selon un mode de réalisation.

La figure 1A comprend une vue (a) représentant de façon très schématique une structure comprenant un premier substrat 101, sur la face supérieure duquel repose un empilement actif de diode électroluminescente (LED) 103. L'empilement actif de LED 103 est par exemple un empilement de LED inorganique, par exemple à base d'un ou plusieurs matériaux semiconducteurs de type III-V, par exemple à base de nitrure de gallium. Le substrat 101 est par exemple en saphir ou en silicium.

L'empilement actif de LED 103 comprend par exemple, dans l'ordre en partant de la face supérieure du substrat 101, une couche semiconductrice 105 dopée de type N formant une couche de cathode, une couche active 107 et une couche semiconductrice 109 dopée de type P formant une couche d'anode. La couche active 107 comporte par exemple une alternance de couches de puits quantiques, ou boîtes quantiques, en un premier matériau semiconducteur et de couches barrières en un deuxième matériau semiconducteur définissant un empilement de puits quantiques multiples. Bien que cela n'ait pas été détaillé en figure 1A, l'empilement actif de LED 103 peut en outre comporter une ou plusieurs autres couches, par exemple choisies parmi des couches d'injection, de transport ou de blocage de charges (électrons ou trous), des couches tampon, etc.

L'empilement actif de LED 103 peut être formé par épitaxie sur la face supérieure du substrat 101. À titre de variante, l'empilement actif de LED 103 est formé par épitaxie sur un substrat de croissance, non représenté, puis reporté sur la face supérieure du substrat 101.

À ce stade, l'empilement 103 n'est pas encore structuré en LED individuelles. Autrement dit, les couches de l'empilement 103 s'étendent chacune de façon continue et avec une épaisseur sensiblement uniforme sur toute la surface supérieure du substrat 101.

Dans l'exemple illustré, la surface supérieure de la structure de la vue (a) est revêtue d'une couche métallique 111 sur et en contact avec la face supérieure de l'empilement actif de LED 103. La couche métallique 111 peut être une couche unique ou un empilement de plusieurs couches métalliques. À titre d'exemple, on peut prévoir une première couche métallique servant de contact ohmique avec la couche semiconductrice 109 dopée de type P et d'autres couches métalliques sus-jacentes peuvent servir de réflecteur ou de couches de collage.

La figure 1A comprend en outre une vue (b) représentant de façon schématique une structure de contrôle comprenant un deuxième substrat 121 dans et sur lequel ont été formés une pluralité de circuits intégrés élémentaires de contrôle 123, par exemple identiques ou similaires, correspondant respectivement à des circuits intégrés de contrôle de futures puces élémentaires du dispositif 100.

Le substrat 121 peut présenter une structure monobloc, ou peut correspondre à une couche recouvrant un support constitué d'un autre matériau. Le substrat 121 est par exemple en un matériau semiconducteur, par exemple en silicium. À titre d'exemple, le substrat 121 est une plaquette ou un morceau de plaquette en silicium monocristallin, la face supérieure du substrat 121 présentant par exemple une orientation cristalline <111>. Dans l'exemple représenté, le substrat 121 présente une structure multicouche de type silicium sur isolant, également appelée SOI (de l'anglais « Semiconductor On Insulator » - semiconducteur sur isolant), comportant un substrat semiconducteur de support 121a, par exemple en silicium, une couche isolante 121b, par exemple en oxyde de silicium, disposée sur et en contact avec la face supérieure du substrat de support, et une couche semiconductrice supérieure 121c, par exemple en silicium monocristallin, disposée sur et en contact avec la face supérieure de la couche isolante 121b.

Dans l'exemple illustré où le substrat 121 est de type SOI, les circuits élémentaires de contrôle 123 sont par exemple formés dans et sur la couche semiconductrice supérieure 121c du substrat 121. Chaque circuit élémentaire de contrôle 123 comprend par exemple une pluralité de transistors MOS (non détaillés sur les figures 1A à 1I). Les circuits élémentaires de contrôle 123 sont par exemple réalisés en technologie CMOS (de l'anglais « Complementary Metal Oxide Semiconductor » - métal oxyde semiconducteur complémentaire).

Dans cet exemple, chaque circuit élémentaire de contrôle 123 comprend, du côté de sa face supérieure, un ou plusieurs plots métalliques de connexion 125a, 125b, 125c. À titre d'exemple, les plots 125a, 125b, 125c affleurent du côté de la face supérieure d'une couche isolante supérieure, par exemple en oxyde de silicium, d'un empilement d'interconnexion (non détaillé sur les figures) revêtant la face supérieure de la couche semiconductrice supérieure 121c du substrat 121. Ainsi, dans cet exemple, la surface supérieure de la structure de contrôle de la vue (b) est une surface plane comportant une alternance de régions métalliques (les plots 125a, 125b, 125c) et de régions isolantes.

À titre d'exemple, chaque circuit élémentaire de contrôle 123 comprend un plot métallique 125a spécifique pour un élément d'émission de lumière blanche, ou source de lumière blanche, de la future puce élémentaire du dispositif 100, destiné à être connecté à une région d'anode de l'élément d'émission de lumière blanche et permettant de commander individuellement l'émission de lumière par cet élément. Dans cet exemple, chaque circuit élémentaire de contrôle 123 comprend en outre un plot métallique 125b spécifique pour un élément d'émission infrarouge (IR), ou source infrarouge, de la future puce élémentaire du dispositif 100, destiné à être connecté à une région d'anode de l'élément d'émission IR et permettant de commander individuellement l'émission de lumière par cet élément. Chaque circuit élémentaire de contrôle 123 comprend en outre un plot métallique 125c spécifique pour un élément de détection infrarouge, ou élément de capture infrarouge, de la future puce élémentaire du dispositif 100, destiné à être connecté à une région d'anode de l'élément de détection IR et permettant de collecter des charges photogénérées par cet élément.

Par ailleurs, bien que cela n'ait pas été représenté sur les figures 1A à 1I afin de ne pas surcharger le dessin, chaque circuit élémentaire de contrôle 123 peut en outre comprendre un ou plusieurs plots métalliques destinés à être connectés à une ou plusieurs régions de cathode d'un ou plusieurs éléments parmi l'élément d'émission de lumière blanche, l'élément d'émission IR et l'élément de détection IR. À titre d'exemple, le circuit de contrôle 123 comprend un unique plot métallique destiné à être connecté collectivement aux régions de cathode de l'élément d'émission de lumière blanche, de l'élément d'émission IR et de l'élément de détection IR. À titre de variante, le circuit de contrôle 123 comprend un premier plot métallique destiné à être connecté à la région de cathode de l'élément d'émission de lumière blanche et un deuxième plot métallique destiné à être connecté aux régions de cathode de l'élément d'émission IR et de l'élément de détection IR, ou les premier et deuxième plots métalliques sont connectés respectivement aux régions de cathode de l'élément d'émission de lumière blanche et de l'élément d'émission IR et à la région de cathode de l'élément de détection IR.

Chaque circuit élémentaire de contrôle 123 peut comprendre un circuit adapté à contrôler l'émission de lumière blanche par l'élément d'émission de lumière blanche, un autre circuit adapté à contrôler l'émission de rayonnements infrarouge par l'élément d'émission IR, et encore un autre circuit adapté à contrôler la détection de rayonnements infrarouge par l'élément de détection IR.

Dans l'exemple illustré, la surface supérieure de la structure de contrôle de la vue (b) est revêtue d'une couche métallique 127. Dans cet exemple, la couche 127 s'étend de façon continue et avec une épaisseur sensiblement uniforme sur toute la surface supérieure de l'empilement d'interconnexion de la structure de contrôle. Ainsi, la couche 127 connecte les uns aux autres tous les plots métalliques 125a, 125b, 125c de la structure de contrôle. Cela permet de réaliser ultérieurement une étape de collage sans alignement, les plots métalliques 125a, 125b, 125c étant ensuite séparés électriquement lors d'une étape de gravure. La couche métallique 127 peut être une couche unique ou un empilement de plusieurs couches métalliques. De préférence, la couche métallique 127 comprend, du côté de sa face supérieure, une couche en le même matériau que la couche 111.

La figure 1B comprend une vue (a) représentant de façon très schématique la structure de la vue (a) de la figure 1A ayant été retournée par rapport à l'orientation de la figure 1A. Cette opération correspond par exemple à une étape préalable au report de la structure de la vue (a) de la figure 1A sur la face supérieure de la structure de la vue (b) de la figure 1A, reproduite en vue (b) de la figure 1B, en utilisant le substrat 101 comme poignée.

La figure 1C illustre la structure obtenue à l'issue d'une étape ultérieure de report et de fixation de l'empilement actif de LED 103 et de la couche métallique 111 sur la structure de la vue (b) de la figure 1B.

Lors de cette étape, la face inférieure (dans l'orientation de la figure 1B, correspondant à la face supérieure, dans l'orientation de la figure 1A) de la couche métallique 111 est fixée sur la face supérieure de la couche métallique 127. La fixation est par exemple obtenue par collage direct ou collage moléculaire de la face inférieure de la couche 111 sur la face supérieure de la couche 127, c'est-à-dire sans apport de matière entre les deux couches.

Le substrat 101 est ensuite retiré, par exemple par meulage et/ou gravure chimique, de façon à libérer l'accès à la face supérieure de l'empilement actif de LED 103, c'est-à-dire, dans cet exemple, la face supérieure de la couche semiconductrice de cathode 105 de l'empilement actif de LED 103. À titre de variante, le retrait du substrat 101 peut être effectuée par décollement au laser (« laser lift-off », en anglais), par exemple dans le cas où le substrat 101 est en corindon (« sapphire », en anglais).

La figure 1D illustre une étape de formation de tranchées 129 s'étendant verticalement dans l'empilement actif de LED 103 depuis sa face supérieure et délimitant latéralement, dans l'empilement 103, une pluralité d'îlots 131 correspondant à des LED individuelles des futures puces élémentaires du dispositif. Les tranchées 129 sont par exemple formées par gravure plasma. En vue de dessus (non représentée), les tranchées 129 forment une grille séparant latéralement les îlots 131 les uns des autres.

La figure 1D illustre en outre une étape ultérieure de prolongement vertical des tranchées 129 à travers les couches métalliques 111 et 127, par exemple un utilisant le même masque de gravure (non représenté) que celui utilisé à l'étape précédente. À l'issue de cette étape, les tranchées 129 débouchent sur la face supérieure de l'empilement d'interconnexion revêtant la face supérieure du substrat 121.

La portion de l'empilement des couches 111 et 127 subsistant sous chaque LED 131 à l'issue de cette étape constitue une électrode d'anode de la LED. Ladite électrode d'anode est en contact, par sa face inférieure, avec la face supérieure d'un plot métallique de connexion 125a ou 125b du circuit élémentaire de contrôle 123 sous-jacent. Ainsi, chaque LED 131 a son électrode d'anode connectée individuellement à un plot métallique de connexion 125a d'un circuit élémentaire de contrôle 123.

Dans cet exemple, une tranchée 129 est en outre formée en vis-à-vis de chaque plot métallique de connexion 125c de façon à libérer l'accès à la face supérieure des plots 125c. Par ailleurs, bien que cela n'ait pas été illustré, une tranchée 129 est par exemple en outre formée en vis-à-vis de chaque plot métallique de connexion de cathode de façon à libérer l'accès à sa face supérieure. À titre de variante, le contact peut être réalisé en face arrière par des vias conducteurs traversants, par exemple de type TSV (de l'anglais « Through-Silicon Via ») après amincissement du substrat 121.

La figure 1E illustre une étape ultérieure de passivation des flancs des LED 131. Pour cela, une couche 133 en un matériau électriquement isolant, par exemple de l'oxyde de silicium ou du nitrure de silicium, est déposée par une méthode de dépôt conforme sur la face supérieure de la structure. La couche 133 revêt alors la face supérieure et les flancs des LED 131 ainsi que les flancs des portions des couches métalliques 111 et 127 situées sous les LED 131 et, au fond des tranchées 129, la face supérieure de l'empilement d'interconnexion revêtant le substrat 121. Une étape de gravure anisotrope verticale est ensuite mise en œuvre pour retirer les portions horizontales de la couche 133 et conserver uniquement les portions verticales de cette couche, revêtant les flancs des LED 131 et les flancs des portions des couches métalliques 111 et 127 situées sous les LED 131.

La figure 1E illustre en outre une étape ultérieure de remplissage des tranchées 129 par un matériau isolant 135. À titre d'exemple, le matériau isolant 135 est initialement déposé sur toute la surface supérieure de la structure avec une épaisseur supérieure à la profondeur des tranchées 129, de façon à combler entièrement les tranchées 129. Une étape de planarisation, par exemple par polissage mécano-chimique, est ensuite mise en œuvre pour libérer l'accès à la face supérieure des LED 131. On obtient ainsi une surface supérieure sensiblement plane sur laquelle affleurent les régions semiconductrices de cathode 105 des LED 131, et les régions isolantes 135 remplissant les tranchées 129. En vue de dessus (non représentée), les régions isolantes 135 forment une grille isolante séparant latéralement les LED 131 les unes des autres. À titre d'exemple, les régions isolantes 135 sont en un matériau polymère ou, plus généralement, en tout type de matériau utilisé pour former une couche de planarisation.

La figure 1F illustre une étape ultérieure de formation de tranchées s'étendant verticalement dans les régions isolantes 135 à l'aplomb des plots métalliques de connexion 125c. Les tranchées s'étendent plus précisément depuis la face supérieure des régions isolantes 135 et débouchent sur la face supérieure des plots métalliques de connexion 125c.

La figure 1F illustre en outre une étape ultérieure de remplissage des tranchées formées dans les régions isolantes 135 par un empilement actif de photodétecteur 137. L'empilement actif de photodétecteur 137 comprend par exemple, dans l'ordre en partant de la face supérieure du substrat 121, une couche semiconductrice dopée de type P formant une couche d'anode, une couche active, et une couche semiconductrice dopée de type N formant une couche de cathode. L'empilement actif de photodétecteur est par exemple réalisé à partir de matériaux inorganiques, la couche active comprenant par exemple une pluralité de puits ou boîtes quantiques (« quantum dots », en anglais), ou à partir de matériaux organiques. La couche active est par exemple une couche comportant des boîtes quantiques dans une matrice polymère. Dans le cas de matériaux organiques, l'empilement actif de photodétecteur 137 peut être réalisé par enduction centrifuge (« spin-coating », en anglais). Dans l'exemple représenté, les faces latérales de chaque photodétecteur 137 sont revêtues du matériau isolant 135, le matériau 135 étant par exemple situé sur et en contact avec toutes les faces latérales du photodétecteur 137. Bien que cela n'ait pas été détaillé, un empilement d'une ou plusieurs couches d'injection et/ou de transport de trous (non représenté) peut être déposé sur le fond des tranchées préalablement au dépôt de la couche active.

La figure 1F illustre en outre une étape ultérieure de dépôt, sur la face supérieure de la structure, d'une couche conductrice 139 transparente aux longueurs d'onde d'émission des LED et aux longueurs d'onde de détection des photodétecteurs du dispositif. La couche 139 s'étend par exemple de façon continue et avec une épaisseur sensiblement uniforme sur toute la surface supérieure de la structure. La couche 139 est par exemple en un oxyde conducteur transparent, par exemple en oxyde d'indium-étain (ITO). À titre de variante, la couche 139 peut être une couche métallique suffisamment mince pour être transparente, par exemple une couche d'argent d'épaisseur inférieure à 80 nm.

La couche 139 est en contact, par sa face inférieure, avec la face supérieure des régions semiconductrices de cathode 105 des LED 131 et avec la face supérieure des photodétecteurs 137. La couche 139 connecte par exemple électriquement la région semiconductrice de cathode 105 de chaque LED 131 et la couche de cathode de chaque photodétecteur 137 à une métallisation de contact de cathode commune de la structure (non représentée). La personne du métier est toutefois capable, à partir des indications de la présente description, de prévoir des couches analogues à la couche 139 isolées les unes des autres et connectées à des métallisations de contact de cathode différentes.

La figure 1G illustre une étape ultérieure de formation de convertisseurs de couleur 141a à l'aplomb des LED 131 situées en contact avec les plots métalliques 125a et de convertisseurs visible vers infrarouge 141b à l'aplomb des LED 131 situées en contact avec les plots métalliques 125b.

À titre d'exemple, les LED 131 sont destinées à émettre de la lumière bleue. Dans ce cas, chaque convertisseur 141a est par exemple configuré pour convertir la lumière bleue émise par la LED 131 sous-jacente en lumière blanche et chaque convertisseur 141b est par exemple configuré pour convertir la lumière bleue émise par la LED 131 sous-jacente en rayonnement IR. Dans le cas où les LED 131 émettent de la lumière bleue, les convertisseurs 141a sont par exemple des convertisseurs blancs comprenant un mélange de matériaux permettant respectivement d'opérer une conversion de la lumière bleue en lumière rouge et en lumière verte tout en laissant passer une partie de la lumière bleue. Chaque convertisseur 141a est ainsi configuré pour transmettre, à partir de la lumière bleue émise par la LED 131 sous-jacente, de la lumière blanche formée à partir de lumière verte, rouge et bleue.

Les convertisseurs 141a et 141b sont par exemple réalisés à base de phosphores, de boîtes quantiques, de couches minces en matériau pérovskite, etc. À titre d'exemple, les convertisseurs 141a et 141b sont formés par dépôts successifs.

Bien que cela n'ait pas été illustré en figure 1G, des barrières opaques peuvent être prévues entre les convertisseurs pour éviter les phénomènes de diaphotie (crosstalk optique). Dans ce cas, une couche opaque, par exemple une couche de résine noire, est par exemple déposée sur toute la face supérieure de la couche conductrice 139 et les convertisseurs 141a et 141b sont par exemple réalisés dans des cavités préalablement formées dans la couche opaque.

La figure 1G illustre en outre une étape de formation, à l'aplomb des LED 131 et des photodétecteurs 137, de microlentilles 143.

Dans l'exemple représenté, la microlentille 143 située à l'aplomb de chaque LED 131 est disposée sur et en contact avec la face supérieure du convertisseur 141a, 141b associé à la LED 131. Par ailleurs, dans cet exemple, la microlentille 143 située à l'aplomb de chaque photodétecteur 137 est disposée sur et en contact avec la face supérieure de la couche conductrice 139.

À titre d'exemple, les microlentilles 143 peuvent être formées par photolithographie puis gravure. À titre de variante, les microlentilles 143 peuvent être disposées sur un support, par exemple un film, rapporté du côté de la face supérieure de la structure. Bien que la figure 1G illustre un exemple de réalisation mettant en œuvre des microlentilles 143, tout type de composant optique destiné à focaliser, ou formater, un faisceau peut, à titre de variante, être utilisé.

Dans l'exemple illustré, la structure de la figure 1G comporte :
- des éléments 145a d'émission de lumière blanche, comprenant chacun la LED 131, le convertisseur 141a et la microlentille 143 situés à l'aplomb de l'un des plots métalliques 125a ;
- des éléments 145b d'émission de rayonnements infrarouge, ou éléments 145b d'émission infrarouge, comprenant chacun la LED 131, le convertisseur 141b et la microlentille 143 situés à l'aplomb de l'un des plots métalliques 125b ; et
- des éléments 145c de détection de rayonnements infrarouge, destinés à détecter les rayonnements infrarouge émis par les éléments 145b, comprenant chacun le photodétecteur 137 et la microlentille 143 situés à l'aplomb de l'un des plots métalliques 125c.

Les éléments 145a, 145b et 145c sont, comme dans l'exemple illustré en figure 1G, sensiblement coplanaires. Dans l'exemple représenté, les LED 131 des éléments d'émission 145a de lumière blanche et les LED 131 des éléments 145b d'émission IR sont destinées à émettre de la lumière visible dans une même plage de longueurs d'onde.

Le procédé décrit ci-dessus en relation avec les figures 1A à 1G peut être utilisé pour réaliser un dispositif de rétroéclairage et de détection de gestes monolithique. Les figures 1H et 1I décrites ci-dessous sont par exemple mises en œuvre à la suite des étapes des figures 1A à 1G dans un cas où l'on souhaite réaliser un dispositif de rétroéclairage et de détection de gestes de plus grandes dimensions.

La figure 1H illustre une étape de formation de tranchées 147 délimitant latéralement une pluralité de puces semiconductrices 149 correspondant à des puces élémentaires du dispositif 100 de rétroéclairage et de détection de gestes. Dans l'exemple représenté, les tranchées 147 s'étendent verticalement dans la structure depuis la face supérieure de la couche conductrice 139 jusqu'à la face inférieure du substrat 121. Les tranchées 147 peuvent être formées par gravure plasma, par sciage, ou par toute autre méthode de découpe adaptée.

À titre d'exemple, un substrat de support temporaire (non représenté), par exemple un film, peut être utilisé pour maintenir mécaniquement les puces élémentaires 149 lors et à l'issue de l'opération de découpe.

La figure 1I illustre une étape ultérieure de fixation de puces élémentaires 149 sur la face supérieure d'un même substrat de report 151, par exemple un substrat en verre, du dispositif 100 de rétroéclairage et de détection de gestes. Le substrat de report 151 est par exemple un substrat de contrôle des puces élémentaires 149. Le substrat de report 151 comprend par exemple, du côté de sa face supérieure, une pluralité de plots métalliques de connexion (non représentés) destinés à être fixés et connectés électriquement et mécaniquement à des plots métalliques de connexion correspondants (non représentés) des puces élémentaires 149. Les puces élémentaires 149 sont par exemple disposées sur le substrat de report 151 de sorte à placer les plots métalliques de connexion de puces élémentaires 149 en vis-à-vis de plots métalliques de connexion correspondants du substrat de report 151. Les plots en vis-à-vis sont ensuite fixés et connectés électriquement, par exemple par collage direct, par soudure, au moyen de microtubes, ou par toute autre méthode adaptée. Les éléments 145a, 145b et 145c sont ainsi connectés électriquement au substrat 151. Bien que cela n'ait pas été détaillé en figure 1I afin de ne pas surcharger le dessin, le substrat 151 comporte par exemple des pistes conductrices, par exemple organisées selon des lignes et des colonnes, permettant de relier les plots métalliques de connexion.

Dans un cas où un substrat de support temporaire est utilisé, les puces élémentaires 149 sont, une fois fixées au substrat de report 151, détachées du substrat de support temporaire, et ce dernier est retiré. On réalise ainsi un transfert collectif simultané d'une pluralité de puces élémentaires 149 du substrat de support temporaire vers le substrat de report 151. Le pas, c'est-à-dire la distance centre à centre en vue de face, des puces élémentaires 149 sur le substrat de report 151 est par exemple un multiple du pas des puces élémentaires 149 sur le substrat de support temporaire. Ainsi, seule une partie des puces élémentaires est transférée simultanément du substrat de support temporaire sur le substrat de report 151. Les autres puces restent attachées au substrat de support temporaire et peuvent être reportées ultérieurement sur une autre partie du substrat de report 151 ou sur un autre substrat de report.

À titre de variante, des puces élémentaires 149 peuvent être disposées successivement sur le substrat de report 151 par un robot dit de « pick-and-place ».

On a décrit ci-dessus un exemple de réalisation dans lequel chaque puce élémentaire 149 comprend un empilement d'un circuit intégré de contrôle, par exemple un circuit CMOS, et un élément 145a d'émission de lumière blanche, un élément 145b d'émission IR et un élément 145c de détection IR.

À titre de variante, chaque puce élémentaire 149 peut comprendre un ou plusieurs éléments, parmi les éléments 145a, 145b et 145c, les autres éléments faisant alors partie d'une ou plusieurs autres puces élémentaires analogues à la puce élémentaire 149. À titre d'exemple, des premières puces élémentaires comprennent chacune un élément 145a d'émission de lumière blanche et un élément 145b d'émission IR et des deuxièmes puces élémentaires comprennent chacune un élément 145c de détection IR, les circuits 123 de contrôle des éléments 145a, 145b et 145c étant par exemple intégrés aux premières puces élémentaires. Cela permet par exemple de réaliser les photodétecteurs 137 des éléments 145c de détection IR en arséniure de gallium-indium (InGaAs). À titre de variante, les premières puces élémentaires peuvent comprendre chacune uniquement l'élément 145a d'émission de lumière blanche, les deuxièmes puces élémentaires comprenant alors chacune un élément 145b d'émission IR et un élément 145c de détection IR, les circuits 123 de contrôle des éléments 145a, 145b et 145c étant par exemple intégrés aux premières puces élémentaires. Dans cette variante, le dispositif 100 peut comporter des nombres égaux ou différents de premières et de deuxièmes puces élémentaires. À titre d'exemple, le dispositif 100 peut comprendre davantage de premières puces, comportant l'élément 145a, que de deuxièmes puces, comportant les éléments 145b et 145c.

Bien que seules quatre puces élémentaires 149 aient été illustrées en figure 1I à des fins de simplification, le dispositif 100 peut bien entendu comporter un nombre de puces élémentaires 149 plus important que celui illustré, par exemple plusieurs centaines ou plusieurs milliers de puces élémentaires 149.

Par ailleurs, bien que cela n'ait pas été détaillé sur les figures, les circuits intégrés élémentaires de contrôle 123 des puces élémentaires 149 peuvent en outre être utilisés pour contrôler des éléments externes aux puces élémentaires, par exemple choisis parmi des transducteurs électromécaniques, des transducteurs optoélectroniques, des transducteurs thermoélectriques, des éléments de capture d'énergie, des éléments de stockage d'énergie, etc.

La figure 2A et la figure 2B représentent, par des vues de côté et en coupe, schématiques et partielles, des étapes successives d'une variante du procédé de fabrication du dispositif 100 de rétroéclairage et de détection de gestes des figures 1A à 1I.

La figure 2A illustre une étape de report de puces élémentaires 249 sur la face supérieure du substrat de report 151. Les puces élémentaires 249 sont par exemple analogues aux puces élémentaires 149, mais dépourvues des convertisseurs 141a, 141b et des photodétecteurs 137. Comme les puces élémentaires 149, chaque puce élémentaire 249 comprend les deux LED 131 situées sur la face supérieure de portions du substrat 121 qui subsistent à l'issue d'une étape de découpe par exemple analogue à celle précédemment décrite en relation avec la figure 1H.

La figure 2B illustre une étape de report, du côté de la face supérieure de la structure, d'un support 251, par exemple un film, intégrant, pour chaque puce élémentaire 249, les convertisseurs 141a, 141b et le photodétecteur 137. Une fois le support 251 reporté sur les puces élémentaires 249, les convertisseurs 141a, 141b et les photodétecteurs 137 sont situés à l'aplomb respectivement des LED 131 et des plots métalliques de connexion 125c.

La figure 2B illustre en outre une étape de formation ou de report des microlentilles 143 à l'aplomb des convertisseurs 141a, 141b et des photodétecteurs 137. Les microlentilles 143 sont par exemple portées par le support 251. À titre de variante, les microlentilles 143 peuvent être disposées sur un support, par exemple un film, rapporté du côté de la face supérieure de la structure, par exemple sur et en contact avec le support 251, ou les microlentilles 143 sont formées sur le support 251 par photolithographie puis gravure.

À l'issue de ces étapes, un dispositif 200 de rétroéclairage et de détection de gestes analogue au dispositif 100 est obtenu.

La figure 3 illustre, de façon schématique et partielle, un exemple d'intégration du dispositif de rétroéclairage et de détection de gestes des figures 1A à 1I dans un dispositif 300 d'affichage à cristaux liquides.

Dans l'exemple représenté, le dispositif 300 comprend deux polariseurs 301a et 301b, par exemple des polariseurs rectilignes croisés, disposés de part et d'autre d'une matrice de cristaux liquides 303 et situés à l'aplomb du dispositif 100 de rétroéclairage et de détection de gestes. Chacune des puces élémentaires 149 du dispositif 100 (non détaillées en figure 3) émet de la lumière blanche (flèche 305a) et des rayonnements infrarouge (flèche 305b) en direction de la matrice de cristaux liquides 303 et reçoit des rayonnements infrarouge (flèche 305c) en provenance d'un milieu extérieur situé au-dessus de la matrice de cristaux liquides 303, dans l'orientation de la figure 3. La lumière visible émise par les éléments 145a d'émission de lumière blanche permet de mettre en œuvre une fonction de rétroéclairage de la matrice de cristaux liquides 303, par exemple de manière analogue à un dispositif de rétroéclairage dit « back lit ». En outre, les rayonnements IR émis et captés respectivement par les éléments 145b d'émission IR et 145c de détection IR permettent par exemple de mettre en œuvre une fonction de détection de gestes. La mise en œuvre de la fonction de détection de gestes est à la portée de la personne du métier à partir des indications de la présente description.

À titre de variante, on pourrait prévoir de substituer le dispositif 100 par le dispositif 200 dans le dispositif 300 d'affichage à cristaux liquides.

Un avantage des dispositifs 100 et 200 tient au fait qu'ils permettent de combiner, au moyen de composants formés sur un même substrat, des fonctions de rétroéclairage et de détection de gestes. Cela permet par exemple au dispositif 300 intégrant le dispositif 100 ou 200 de présenter un encombrement moindre que si les fonctions de rétroéclairage et de détection de gestes étaient réalisées par des composants formés sur des substrats distincts.

Par ailleurs, le fait de réaliser les LED 131 des éléments d'émission de lumière blanche 145a et les LED 131 des éléments d'émission IR 145b à partir du même empilement actif de LED 103 permet avantageusement de simplifier la fabrication des dispositifs 100 et 200. La fabrication des dispositifs 100 et 200 est en outre facilitée du fait de l'intégration des circuits de contrôle 123 dans les puces 149, ce qui permet avantageusement de s'affranchir de l'utilisation d'une matrice active.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, bien que la présente description prenne pour exemple un cas dans lequel les LED 131 sont destinées à émettre de la lumière bleue, cet exemple n'est pas limitatif et la personne du métier est capable, à partir de la présente description, d'adapter les modes de réalisation décrits à un cas où les LED 131 émettent de la lumière visible autre que de la lumière bleue.

Par ailleurs, la personne du métier est capable, à partir des indications de la présente description, de transposer ce qui a été décrit en prenant pour exemple le cas où la détection de gestes est mise en œuvre à partir de l'émission et de la détection de rayonnements infrarouge au cas où la détection de gestes est réalisée à partir de l'émission et de la détection de lumière visible, les éléments 145b étant alors des éléments d'émission de lumière visible et les éléments 145c étant des éléments de détection de lumière visible, destinés à détecter la lumière visible émise par les éléments 145b. Dans ce cas, les convertisseurs 141b visible vers infrarouge sont par exemple omis et les empilements actifs 137 de photodétecteur des éléments 145c sont par exemple des empilements actifs de photodétecteur visible.

Enfin, la mise en œuvre pratique des modes de réalisation et variantes décrits est à la portée de la personne du métier à partir des indications fonctionnelles données ci-dessus. En particulier, les modes de réalisation décrits ne se limitent pas aux exemples particuliers de matériaux et de dimensions mentionnés dans la présente description.

## Revendications

1. Dispositif (100 ; 200) de rétroéclairage et de détection de gestes comprenant :
- des premiers éléments (145a) d'émission de lumière blanche ;
- des deuxièmes éléments (145b) d'émission de rayonnements infrarouge ou de lumière visible ; et
- des troisièmes éléments (145c) de détection des rayonnements infrarouge ou de la lumière visible émis(e) par les deuxièmes éléments (145b),
dans lequel les premiers (145a), deuxièmes (145b) et troisièmes (145c) éléments sont connectés électriquement à un même substrat (121 ; 151),
le dispositif (100 ; 200) comprenant une pluralité de puces élémentaires (149 ; 249) comportant chacune un ou plusieurs éléments parmi l'un des premiers éléments (145a), l'un des deuxièmes éléments (145b) et l'un des troisièmes éléments (145c).

2. Dispositif (100 ; 200) selon la revendication 1, dans lequel les puces élémentaires (149 ; 249) comportent chacune l'un des premiers éléments (145a), l'un des deuxièmes éléments (145b) et l'un des troisièmes éléments (145c).

3. Dispositif (100 ; 200) selon la revendication 2, dans lequel chaque puce élémentaire (149 ; 249) comporte en outre un circuit élémentaire (123) de contrôle des premier (145a), deuxième (145b) et troisième (145c) éléments.

4. Dispositif (100 ; 200) selon la revendication 1, comprenant :
- une pluralité de premières puces élémentaires comportant chacune l'un des premiers éléments (145a) et l'un des deuxièmes éléments (145b) ; et
- une pluralité de deuxièmes puces élémentaires comportant chacune l'un des troisièmes éléments (145c).

5. Dispositif selon la revendication 4, dans lequel chaque première puce élémentaire comporte en outre un circuit élémentaire (123) de contrôle des premier (145a), deuxième (145b) et troisième (145c) éléments.

6. Dispositif (100 ; 200) selon la revendication 4 ou 5, dans lequel chaque troisième élément (145c) est un photodétecteur infrarouge à base d'arséniure d'indium-gallium.

7. Dispositif (100 ; 200) selon la revendication 1, comprenant :
- une pluralité de premières puces élémentaires comportant chacune l'un des premiers éléments (145a) ; et
- une pluralité de deuxièmes puces élémentaires comportant chacune l'un des deuxièmes éléments (145b) et l'un des troisièmes éléments (145c).

8. Dispositif selon la revendication 7, dans lequel chaque première puce élémentaire comporte en outre un circuit élémentaire (123) de contrôle des premier (145a), deuxième (145b) et troisième (145c) éléments.

9. Dispositif (100 ; 200) selon l'une quelconque des revendications 1 à 8, dans lequel chaque premier élément (145a) comprend une première diode électroluminescente (131) surmontée d'un premier convertisseur (141a) de couleur.

10. Dispositif (100 ; 200) selon l'une quelconque des revendications 1 à 9, dans lequel chaque deuxième élément (145b) comprend une deuxième diode électroluminescente (131) surmontée d'un deuxième convertisseur (141b) visible vers infrarouge.

11. Dispositif (100 ; 200) selon les revendications 9 et 10, dans lequel les première et deuxième diodes électroluminescentes (131) sont destinées à émettre de la lumière visible dans une même plage de longueurs d'onde, de préférence de la lumière bleue.

12. Dispositif (300) d'affichage à cristaux liquides comportant :
- un dispositif (100 ; 200) de rétroéclairage et de détection de gestes selon l'une quelconque des revendications 1 à 11 ; et
- à l'aplomb du dispositif (100 ; 200) de rétroéclairage et de détection de gestes, une matrice de cristaux liquides (303) de part et d'autre de laquelle sont situés des polariseurs (301a, 301b).

13. Procédé de fabrication d'un dispositif (100 ; 200) de rétroéclairage et de détection de gestes comportant une étape de formation, sur un même substrat (121 ; 151) :
- de premiers éléments (145a) d'émission de lumière blanche ;
- de deuxièmes éléments (145b) d'émission de rayonnements infrarouge ou de lumière visible ; et
- de troisièmes éléments (145c) de détection des rayonnements infrarouge ou de la lumière visible émis(e) par les deuxièmes éléments (145b),
le dispositif (100 ; 200) comprenant une pluralité de puces élémentaires (149 ; 249) comportant chacune un ou plusieurs éléments parmi l'un des premiers éléments (145a), l'un des deuxièmes éléments (145b) et l'un des troisièmes éléments (145c).

14. Procédé selon la revendication 13, comprenant en outre une étape de formation de premières et deuxièmes diodes électroluminescentes (131) des premiers (145a) et deuxièmes (145b) éléments à partir d'un même empilement actif (103) de diode électroluminescente.

15. Procédé selon la revendication 14, comprenant en outre une étape de formation de premiers convertisseurs (141a) de couleur, à l'aplomb des premières diodes électroluminescentes (131), et de deuxièmes convertisseurs (141b) visible vers infrarouge, à l'aplomb des deuxièmes diodes électroluminescentes (131).

16. Procédé selon la revendication 14, comprenant en outre une étape de report, sur les premières et deuxièmes diodes électroluminescentes (131), d'un film (251) comprenant :
- des premiers convertisseurs (141a) de couleur, destinés à être placés à l'aplomb des premières diodes électroluminescentes (131) ;
- des deuxièmes convertisseurs (141b) visible vers infrarouge, destinés à être placés à l'aplomb des deuxièmes diodes électroluminescentes (131) ; et
- des empilements actifs (137) de photodétecteur infrarouge des troisièmes éléments (145c), destinés à être placés à l'aplomb de plots de connexion (125c) des troisièmes éléments (145c).
